(19) Europäisches Patentamt

European Patent Office

Office européen des brevets

(11) **EP 0 791 200 B1**

(12) **EUROPÄISCHE PATENTSCHRIFT**

(45) Veröffentlichungstag und Bekanntmachung des Hinweises auf die Patenterteilung:
**01.07.1998 Patentblatt 1998/27**

(21) Anmeldenummer: **95936430.8**

(22) Anmeldetag: **10.11.1995**

(51) Int Cl.⁶: **G06F 17/40**, H03M 1/20

(86) Internationale Anmeldenummer:
**PCT/DE95/01556**

(87) Internationale Veröffentlichungsnummer:
**WO 96/15502 (23.05.1996 Gazette 1996/23)**

(54) **VERFAHREN ZUR SCHNELLEN DIGITALEN ERFASSUNG UND AUFBEREITUNG VON ANALOGEN MESSWERTEN IN EINEM PROZESSOR MIT EINGESCHRÄNKTER BINÄRER WORTBREITE**

PROCESS FOR THE RAPID DIGITAL ACQUISITION AND PROCESSING OF ANALOGUE MEASURED VALUES IN A PROCESSOR WITH RESTRICTED BINARY WORD LENGTH

PROCEDE POUR LA SAISIE ET LE TRAITEMENT NUMERIQUES RAPIDES DE VALEURS DE MESURE ANALOGIQUES DANS UN PROCESSEUR A LONGUEUR DE MOT BINAIRE REDUITE

(84) Benannte Vertragsstaaten:
**AT CH DE ES FR GB IT LI NL PT SE**

(30) Priorität: **11.11.1994 DE 4440305**

(43) Veröffentlichungstag der Anmeldung:
**27.08.1997 Patentblatt 1997/35**

(73) Patentinhaber: **SIEMENS AKTIENGESELLSCHAFT 80333 München (DE)**

(72) Erfinder: **CUYLEN, Michael D-90513 Zirndorf (DE)**

(56) Entgegenhaltungen:
DE-A- 3 210 571        DE-A- 3 820 144
GB-A- 2 122 041

- PATENT ABSTRACTS OF JAPAN vol. 013 no. 005 (E-701) ,9.Januar 1989 & JP,A,63 217816 (MITSUBISHI ELECTRIC CORP) 9.September 1988,
- PATENT ABSTRACTS OF JAPAN vol. 013 no. 277 (E-778) ,26.Juni 1989 & JP,A,01 064416 (NEC CORP) 10.März 1989,
- PATENT ABSTRACTS OF JAPAN vol. 005 no. 205 (E-088) ,25.Dezember 1981 & JP,A,56 125115 (MITSUBISHI ELECTRIC CORP) 1.Oktober 1981,
- PATENT ABSTRACTS OF JAPAN vol. 009 no. 189 (E-333) ,6.August 1985 & JP,A,60 057733 (RICOH KK) 3.April 1985,
- PATENT ABSTRACTS OF JAPAN vol. 011 no. 015 (P-536) ,16.Januar 1987 & JP,A,61 188781 (MATSUSHITA ELECTRIC IND CO LTD) 22.August 1986,
- PATENT ABSTRACTS OF JAPAN vol. 016 no. 497 (E-1279) ,14.Oktober 1992 & JP,A,04 183087 (MATSUSHITA ELECTRIC IND CO LTD) 30.Juni 1992,

**Beschreibung**

Die Erfindung betrifft das Problem, daß in einer digitalen Vorrichtung, welche analoge Meßwerte erfaßt und digitalisiert, die digitale Verarbeitungseinheit eine geringere binäre Wortbreite aufweist als die zu verarbeitenden Meßwerte. Dieses Problem tritt insbesondere dann auf, wenn als digitale Verarbeitungseinheit ein kostengünstiger Mikroprozessor mit geringer Busbreite eingesetzt werden muß.

In der digitalen Meßtechnik und in der Prozeßautomatisierung ist es vielfach notwendig, analoge Meßwerte aus dem z.B. mit einer speicherprogammierbaren Steuerung geführten technischen Prozeß zu erfassen und weiterzuverarbeiten. Hierzu werden diese analogen Meßwerte mit Hilfe von sogenannten Analogwert - Eingabebaugruppen in einem festen zeitlichen Raster, welches häufig Abtastzyklus genannt wird, abgetastet und anschließende analog- digital- konvertiert. Hierbei treten die Meßwerte mit einer durch die binäre Wortbreite am Ausgang des eingesetzten Analog-Digital-Wandlers und durch die jeweils vorliegenden Genauigkeitsanforderungen bedingten binären Wortbreite auf, z.B. mit einer Wortbreite von 16 oder 32-Bit.

Aus der DE 32 10 571 ist eine Analog-Digital-Wandler-Einrichtung bekannt. Dabei ist eine Anpassungsvorrichtung für das dem Analog-Digital-Wandler zugeführte analoge Signal vorhanden, womit dieses um eine Stufe verstärkt oder abgeschwächt werden kann. Hiermit wird das analoge Eingangssignal auf den vorgegebenen Arbeitsbereich des eingesetzten Analog-Digital-Wandlers abgestimmt. Abschließend wird das hieraus resultierende digitale Ausgangssignal mit einem gleichzeitig durch eine Kalibrierungsvorrichtung aufbereiteten digitalen Signal in Relation gebracht, wodurch die Verstärkung oder Abschwächung des analogen Eingangssignals im Sinne einer Meßbereichsanpassung korrigiert wird.

Aus der DE 38 20 144 ist ein hochauflösender A/D- bzw. D/A-Umsetzer bekannt. Dabei ist dem Analog-Digital-Umsetzer ein Verstärker mit programmierter Verstärkung vorgeschaltet. Durch entsprechende Auswahl der Verstärkerstufen kann dem Analog-Digital-Umsetzer das ohne Erreichung einer Übersteuerung größtmögliche Signal zugeführt werden. Das auf diese Weise mit einem bestimmten Faktor verstärkte Eingangssignal wird nach der Umsetzung in ein digitales Wort mit dem digitalen Kehrwert des Faktors multipliziert, so daß die Wortlänge des umgesetzten Signals vergrößert wird. Hierzu sind entsprechend viele Verstärker in Kaskade geschaltet und an jeden Verstärkerausgang ein A/D-Umsetzer angeschlossen. Mit einem Auswahlschalter wird einem Multiplizierer das Ausgangssignal desjenigen Verstärkers zugeführt, der ohne Übersteuerung das größte Signal liefert. Dem Multiplizierer wird schließlich der Kehrwert der Verstärkung der dem ausgewählten Umsetzer vorgeschalteten Verstärkerkette zugeführt.

Zur Aufbereitung und Weiterverarbeitung der Meßwerte werden in digitalen Systemen der technischen Meßtechnik vielfach aus Kostengründen Prozessoren eingesetzt, welche hardwaremäßig nur eingeschränkte Wortbreiten aufweisen. Die binären Wortbreiten derartiger Prozessoren betragen in der Regel nur 4-, 8- bzw. max. 16-3it. So tritt das Problem auf, daß Verarbeitungswerte, z.B. aus einem technischen Prozeß abgetastete digitale Meßwerte, welche eine binäre Wortbreite von z.B. 16-Bit aufweisen, von einem Mikroprozessor weiterverarbeitet werden müssen, der demgegenüber eine eingeschränkte binäre Wortbreite aufweist, z.B. einen nur 8-Bit breiten internen Datenbus.

Eine derartige Verarbeitung muß somit sequentiell erfolgen, indem der z.B. 16-Bit "breite" digitale Verarbeitungswert durch Aufwendung von mehreren Zyklen des Prozessors fragmentweise weiterverarbeitet wird. In Off-line-Systemen ist diese rechenzeitintensive, blockweise Verarbeitung von " überbreiten " Verarbeitungswerten in der Regel unkritisch. Laufzeitprobleme treten aber in sogenannten On-line-Systemen auf, bei denen aus einem technischen Prozeß analoge Meßwerte, z.B. Temperaturen, Drücke, Weg- und Winkelwerte und vieles mehr, in einem u.U. hohen Abtastzyklus möglichst quasi in Echtzeit erfaßt, digitalisiert und weiterverarbeitet werden müssen. Es ist somit notwendig, bei Einsatz eines Prozessors mit einer demgegenüber kleineren Wortbreite einen Ausgleich zwischen den unterschiedlichen Anforderungen einer einerseits genauen Verarbeitung von Verarbeitungswerten mit großer binärer Wortbreite und einer andererseits ausreichend schnellen Verarbeitung derselben zu finden. Analoge Meßwerte müssen nämlich nach deren Digitalisierung in aller Regel einer Aufbereitung unterzogen werden, bevor diese zur Weiterverarbeitung freigebbar sind, d.h. z.B. einem programmtechnisch realisierten Abtastregelsystem als Meßwerte zugeführt werden können. Bei dieser Aufbereitung werden eine Normierung und eine Korrektur des digitalisierten Meßwertes vorgenommen.

Bei der Normierung handelt es sich um eine übliche Meßbereichsanpassung, d.h. die Dehnung oder Stauchung des Wertebereiches einer digitalisierten Meßgröße auf einen anwendungsabhängig notwendigen Wertebereich. Hierzu muß die digitalisierte Meßgröße mit einem "Normierungsfaktor" multipliziert werden, welcher nach unterschiedlichen Strategien gebildet werden kann. Eine derartige digitale Multiplikation beansprucht in einem binären Rechensystem erheblich Rechenzeit. Unter der vorliegenden Randbedingung, daß die binäre Wortbreite des verarbeitenden Prozessors gegenüber der binären Wortbreite des zu verarbeitenden Meßwertes eingeschränkt ist, kommt hinzu, daß bei der Durchführung einer Multiplikation pro Prozessortaktzyklus nur Teilblöcke eines Meßwertes verarbeitbar sind, d.h. für eine derartige Operation mehrere Taktzyklen aufgewendet werden müssen, während denen der Prozessor für andere Aufgaben blockiert ist.

Bei der Korrektur handelt es sich um eine übliche Beseitigung von Störeinflüssen, welche vom Meßwerterfassungssystem selbst hervorgerufen werden und den analogen Meßwert verfälschen. Derartige Störeinflüsse entstehen z.B. in Schaltungsteilen, welche zur Meßbereichsanpassung der analogen Meßwerte auf einen zum Zwecke einer ordnungsgemäßen Digitalisierung notwendigen analogen Wertebereich dienen. Sie sind bedingt durch kurzfristige temperaturabhängige Signaldriftungen, langfristige alterungsbedingte Pegelverschiebungen in der Schaltung, herstellungsbedingte Streuungen von Bauelementekennwerten u.v.m.. Derartige in Analogwert-Eingabebaugruppen auftretenden Störeinflüsse bewirken vom Ein- bis Ausgang des Gesamtsystems einen sogenannten Spannungsoffset des jeweiligen Meßwertes. Zu dessen Kompensation muß der Meßwert nach dessen Digitalisierung durch einen Korrekturfaktor dividiert werden. Eine derartige Division beansprucht in einem binären Rechensystem noch erheblich mehr Rechenzeit als die zur Normierung benötigte Multiplikation. Unter der vorliegenden Randbedingung, daß die binäre Wortbreite des Prozessors gegenüber der Wortbreite des zu verarbeitenden Meßwertes eingeschränkt ist, kommt hinzu, daß bei der Durchführung einer binären Division pro Prozessortaktzyklus wiederum nur Teilblöcke der Meßwerte verarbeitbar sind, d.h. für eine derartige Operation mehrere Taktzyklen aufgewendet werden müssen, während denen der Prozessor für andere Aufgaben blockiert ist.

Ein digitaler Verarbeitungswert, insbesondere analoger Meßwert nach dessen Digitalisierung, wird somit zur Aufbereitung im allgemeinen mindestens einer digitalen Multiplikation und einer digitalen Division unterzogen. Wird ein aktueller, analoger Meßwert in digitalisierter Form z.B. mit AMD bezeichnet, so kann die Ableitung eines "aufbereiteten" Meßwertes KMD zusammengefaßt werden zu

$$KMD = NF * \frac{AMD}{KF} \qquad \text{(Gl. 1)}$$

mit

AMD : analoger Meßwert in binärer Form
NF : Normierungsfaktor in binärer Form
KF : Korrekturfaktor in binärer Form
KMD : "aufbereiteter" Meßwert in binärer Form .

Der Erfindung liegt somit die Aufgabe zugrunde, ein Verfahren anzugeben, womit in einem digitalen Rechensystem eine Meßwertaufbereitung, welche in etwa gemäß der obigen Gleichung 1 zumindest eine digitale Multiplikation und eine digitale Division erfordert, zeitoptimal durchgeführt werden kann. Insbesondere sollen auch dann, wenn z.B. in einem digitalen Abtastregelsystem derartige Meßwerte in einem kurzen Abtastzyklus erfaßt werden, jeder einzelne Meßwert vor dessen Weiterverarbeitung z.B. in Regelalgorithmen u.dgl. vom Prozessor des Systems, welcher voraussetzungsgemäß eine nur eingeschränkte binäre Wortbreite aufweist, dennoch so schnell aufbereitet werden können, daß durch diesen Vorgang der gewünscht kurze Abtastzyklus nicht beeinträchtigt wird.

Die Aufgabe wird gelöst mit dem im Anspruch 1 angegebenen Verfahren. Weitere vorteilhafte Ausgestaltungen sind in den Unteransprüchen angegeben.

Erfindungsgemäß werden nun die binäre Multiplikation und Division nicht gemäß der obigen Gleichung 1 ausgeführt. Vielmehr hat es sich erfindungsgemäß gezeigt, daß diese Operationen im binären Rechenraum erheblich einfacher, d.h. unter Aufwendung von erheblich weniger Prozessorzyklen bewältigt werden können, wenn Gleichung 1 in etwa die folgende Form aufweist:

$$KMD \; = \; \left( \frac{NF \; * \; VF}{KF} \right) \; * \; \left( \frac{AMD}{VF} \right) \qquad (Gl. \; 2\;)$$

mit

AMD : analoger Meßwert in binärer Form
NF : Normierungsfaktor in binärer Form
KF : Korrekturfaktor in binärer Form
VF : Verschiebungsfaktor in binärer Form
KMD : aufbereiteter Meßwert in binärer Form .

Gleichung 1 ist somit in Form der Gleichung 2 um einen von der Gestaltung des Meßwerterfassungssystems und dem Typ des darin verwendeten Prozessors abhängigen binären Verschiebungsfaktor erweitert. Dies hat den Vorteil, daß nun das Produkt durch eine vorteilhafte Umstellung in zwei Elemente separiert werden kann, welche in digitalen Prozessoren erheblich leichter zu verarbeiten sind, als die ursprüngliche Gleichung 1. Diese leichtere Verarbeitbarkeit ergibt sich zum einen daraus, daß das erste Element des Produktes von Gleichung 2, d.h.

$$\left( \frac{NF \ * \ VF}{KF} \right) = K \qquad (Gl. \ 3)$$

welches die binären Elemente Normierungsfaktor NF, Korrekturfaktor KF und Verschiebungsfaktor VF enthält, in der Praxis in erster Annäherung als eine Konstante K angesehen werden kann. Der aktuelle Wert des Korrekturfaktors KF, der insbesondere von alterungs- und temperaturdriftbedingten Schwankungen von Schaltungssignalpegeln beeinflußt wird, ändert sich praktisch nur langfristig, während die aktuellen Werte von Normierungs- und Verschiebungsfaktor VF,NF nach der Inbetriebsetzung der Schaltung ohnehin als konstant angesehen werden können. Gemäß der Erfindung ist es somit nicht notwendig, den ersten Klammerausdruck in Gleichung 2, d.h. die Konstante K gemäß Gleichung 3, immer gleichzeitig mit dem zweiten Klammerausdruck in Gleichung 2, d.h. der Aktualisierung eines Meßwertes AMD in Takt des Abtastzyklusses, erneut zu berechnen. Vielmehr kann die Konstante K gemäß Gleichung 3 mit einer erheblich geringeren Aktualitätsrate bzw. u.U. sogar nur ereignisgesteuert erneut berechnet werden. Der Prozessor wird durch diese Maßnahme erheblich entlastet.

Durch Zusammenfassung der Gleichungen 2 und 3 ergibt sich

$$\frac{(K \ * \ AMD)}{VF} \qquad (Gl. \ 4)$$

Bei Anwendung einer weiteren, besonders vorteilhaften Ausgestaltung der Erfindung kann auch bei der Bearbeitung dieses Quotienten mit jedem Takt des Abtastzyklusses, d.h. bei jeder Erfassung eines aktualisierten Meßwertes AMD, erheblich Rechenzeit eingespart werden. Wird nämlich der Verschiebungsfaktor VF geschickt gewählt, so entfällt praktisch die Division. Dies ist erfindungsgemäß dann der Fall, wenn er dem Quadrat des um 1 vergrößerten binäres Wortes entspricht, welches bei der jeweiligen binären Wortbreite WP des Prozessors als maximal möglicher Wert zulässig ist. Weist der Prozessor beispielhaft eine Wortbreite von 8 Bit auf, so stellt in diesem Fall der Verschiebungsfaktor ein 9 Bit Wort dar, bei dem das hochstwertige Bit mit einer 1 und alle niederwertigeren Bits mit einer 0 belegt sind. Bei dieser Ausführung der Erfindung ist das Divisionsergebnis gleichwertig mit der Weiterverarbeitung der höherwertigen Bits des binären Wortes im Zähler von Gleichung 4, d.h. mit den höherwertigen 8 Bits eines 16 Bit Wortes bzw. den höherwertigen 16 Bits eines 32 Bit Wortes im Zähler von Gleichung 4. Mit

VF : binärer Verschiebungsfaktor
WP : binäre Wortbreite des Prozessors
WM : binäre Wortbreite der digitalisierten Meßwerte

und der Einhaltung eines bevorzugten Wertebereiches

$$1 < \frac{WM}{WP} \leq 2 \qquad (Gl. \ 5)$$

für das Verhältnis zwischen der binären Wortbreite WP des Prozessors und der binären Wortbreite WM der digitalisierten Meßwerte gilt für den Verschiebungsfaktor VF in diesem Fall

$$VF = \left( 2^{WP} \right)^2 \qquad (Gl. \ 6)$$

Zahlenbeispiel 1:

WP = 4 Bit
WM = 5 ... 8 Bit
$2^4 = 16$
$(2^4)^2 = 16^2 = VF = \underline{256}$.

Zahlenbeispiel 2:

WP = 5 Bit
WM = 6 ... 10 Bit
$2^5$ = 32
$(2^5)^2 = 32^2$ = VF = <u>1024.</u>

Zahlenbeispiel 3:

WP = 8 Bit
WM = 9 ... 16 Bit
$2^8$ = 256
$(2^8)^2 = 256^2$ = VF = <u>65536.</u>

Zahlenbeispiel 4:

WP = 16 Bit
WM = 17 ... 32 Bit
$2^{16}$ = 65536
$(2^{16})^2 = 65536^2$ = VF = <u>4294967296.</u>

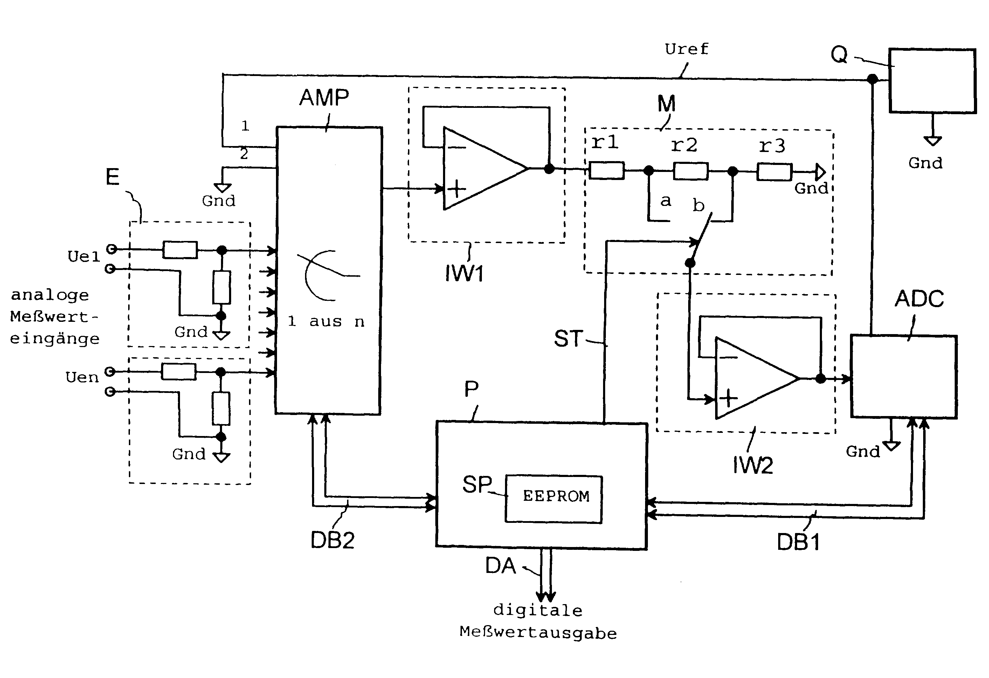

Die Erfindung wird nachfolgend am Beispiel einer in der Figur dargestellten, zur Erfassung und Digitalisierung von analogen Meßwerten Ue1 ... Uen dienenden, sogenannten "Analogwerteeingabe" erläutert. Die dortige "Erfassungskette" beginnt auf der Seite der analogen Meßwerteeingänge, welchen beispielhaft je eine analoge Spannung als Meßwerte Ue1 ... Uen z.B. aus einem technischen Prozeß zugeführt werden. Eine analogen Meßwerten Ue1 ... Uen enthält für jeden Meßwert einen Signalkonverter zum Zwecke einer ersten Voranpassung. In der Figur sind diese beispielhaft als sogenannte Signalpegelkonverter in Form von Spannungsteilerschaltungen ausgeführt. Bei anderen Ausführungen können in der Eingangsschaltung E pro Meßwert auch z.B. Strom-/ Spannungsumsetzer vorgesehen sein. Ein sich anschließender Analogmultiplexer AMP schaltet, über einen zweiten, zur Kanalselektion dienenden Datenbus DB2 von einem zentralen Mikroprozessor P gesteuert, sukzessive die Ausgänge der einzelnen Signalkonverter der Eingangsschaltung E durch und führt somit die analogen Meßwerte Ue1 ... Uen einzeln der weiteren Konvertierungsschaltung zu.

Diese enthält gemäß dem in der Figur dargestellten Beispiel eine Referenzspannungsquelle Q, welche gegenüber einer mit Gnd bezeichneten Bezugsspannung eine im Wert exakt bekannte analoge Referenzspannung Uref langzeitstabil bereitstellt. Diese wird als einheitliche Referenz insbesondere vom Analogmultiplexer AMP, den Signalpegelkonvertern in der Eingangsschaltung E, einer Meßbereichsanpassung M und einem Analog-Digital-Wandler ADC benötigt. Der Analog-Digital-Wandler ADC konvertiert den jeweils vom Analogmultiplexer AMP durchgeschalteten analogen Meßwert und führt das Ergebnis der Digitalisierung über einen ersten Datenbus DB1 dem Mikroprozessor P zu. Dieser bereitet die Meßwerte in deren binärer Form unter zu Hilfenahme von weiteren, in einem EEPROM bezeichneten Speicher SP enthaltenen Daten auf. Zur Aufbereitung kann es vorteilhaft sein, wenn im Speicher SP die aktuellen Werte der Referenzspannung Uref der Referenzspannungsquelle Q und der Bezugsspannung Gnd der gesamten Meßschaltung in digitalisierter Form vorrätig sind. Zu deren Erfassung kann der Analogmultiplexer AMP über den zweiten Datenbus DB2 vom Prozessor P so angesteuert werden, daß die an den Eingängen 1 und 2 dem Analogmultiplexer zugeführten Werte von Uref und Gnd durchgeschaltet, so der Erfassungskette zugeführt und schließlich als digitale Werte am Ausgang des Analog-Digital-Wandler ADC über den ersten Datenbus DB1 im Speicher SP hinterlegbar sind.

Bei dieser Aufbereitung erfolgt eine u.U. für jeden Meßwert individuelle Normierung, d.h. Meßbereichsanpassung, und eine Korrektur von Störeinflüssen, welche von den in der Schaltung der Figur enthaltenen Bauelementen selbst hervorgerufen werden. Wie bereits eingangs dargelegt, ist es hierzu erforderlich, daß die vom ersten Datenbus DB1 gelesenen Meßwerte gemäß der obigen Gleichung 1 einer digitalen Multiplikation mit einem Normierungsfaktor NF und einer digitalen Division mit einem Korrekturfaktor KF unterzogen werden. Erfindungsgemäß wird der Mikroprozessor so betrieben, daß die zur Meßwertaufbereitung notwendigen Operationen so schnell ablaufen, daß hierdurch die Abtastrate, d.h. die Schnelligkeit der Erfassung aktualisierter Werte für die einzelnen analogen Meßwerte Ue1 ... Uen nicht eingeschränkt wird. Dies wird nachfolgend näher erläutert.

Bei dem in der Figur dargestellten Beispiel sind in der Erfassungskette zwischen dem Ausgang des Analogmultiplexers AMP und dem Analog-Digital-Wandler ADC noch zusätzlich angeordnet ein erster Impedanzwandler IW1, eine Meßbereichsanpassung M bestehend aus einer Reihenschaltung von drei Widerständen r1, r2, r3 mit Auswahlschalter und ein zweiter Impedanzwandler IW2. Der Auswahlschalter der Meßbereichsanpassung M weist die Stellungen a, b auf und wird über eine Steuerleitung ST vom Prozessor P abhängig vom aktuellen Meßwert Uen betätigt. Der Mikroprozessor P bewirkt ferner die aktuelle Kanalauswahl des Analogmultiplexers AMP über den zweiten Datenbus DB2 und die Steuerung des Analog-Digital-Wandlers ADC über den ersten Datenbus DB1.

Die Bauelemente in der gesamten Erfassungskette von der Eingangsschaltung E, über die Impedanzwandler IW1, IW2, die Widerstände r1, r2, r3 in der Meßbereichsanpassung M bis hin zum Analog-Digital-Wandler ADC unterliegen einer Vielzahl von Störeinflüssen, insbesondere auf Streuungen, Alterungen und Temperaturen beruhende Driftungen von Kennwerten und Potentialen. Diese müssen vom Mikroprozessor P bevorzugt zyklisch erfaßt und zur Korrektur der Meßwerte herangezogen werden. Unter der Annahme, daß im vorliegenden Beispiel der Prozessor P zyklisch die aktuellen Werte der Referenzspannung Uref und der Bezugsspannung Gnd der Meßschaltung, welche dem Analogmultiplexer AMP an den Eingängen 1,2 zugeführt werden, durch entsprechende Ansteuerung desselben über den zweiten Datenbus DB2 erfaßt, stehen deren digitalisierte Werte im Prozessor zur Verfügung, kann mit

RFD :    aktueller binärer Wert der Referenzspannung Uref der Referenzspannungsquelle Q, und
OFD :    aktueller binärer Wert des Potentials der Bezugsspannung Gnd der Meßschaltung

ein Korrekturfaktor KF der Meßschaltung in der Figur, bzw. u.U. eine Vielzahl derartiger Korrekturfaktoren KF(Uen) separat für jeden einzelnen Meßwert Uen, ermittelt werden als

$$KF(Uen) = RFD - OFD \hspace{4cm} (Gl.7)$$

mit

KF(Uen) :    zu einem Meßwert Uen gehöriger Korrekturfaktor.

Nach Einsetzen dieser Größen in die obige Gleichung 1 ergibt sich unter weiterer Berücksichtigung von

Uen :          beispielhafter analoger Meßwert
AMD(Uen) :    analoger Meßwert Uen in binarer Form
NF(Uen) :      dazugehöriger Normierungsfaktor
KMD(Uen) :    aufbereiteter Meßwert in binärer Form

$$KMD(Uen) = NF(Uen) * \frac{AMD(Uen) - OFD}{KF(Uen)} \hspace{3cm} (Gl.8)$$

Nach Anwendung der erfindungsgemäßen Umstellung gemäß Gleichung 2 auf die obige Gleichung 8 ergibt sich :

$$KMD(Uen) = \left( \frac{NF(Uen) \; * \; VF}{KF(Uen)} \right) * \left( \frac{AMD(Uen) \; - \; OFD}{VF} \right) \hspace{1cm} (Gl. \; 9)$$

Werden desweiteren für die Wortbreiten des Prozessors P und der digitalisierten Meßwerte AMD(Uen) die im obigen Zahlenbeispiel 3 enthaltenen Werte zugrundegelegt, so ergibt sich erfindungsgemäß in diesem Fall für den binären Verschiebungsfaktor VF der Wert :
VF = 65536.

Für den linken Teil des Produktes von Gleichung 9 kann somit geschrieben werden :

$$\left( \frac{NF(Uen) \; * \; 65536}{KF(Uen)} \right) = K \hspace{1cm} (Gl.10)$$

Wie bereits oben ausgeführt, kann in der Praxis dieser Teil vorübergehend, d.h. in der Regel für die Dauer einer größeren Anzahl von Abtastzyklen des Meßwertes AMD(Uen), als eine Konstante K angesehen werden. Es ist somit nicht notwendig, diese Größe immer gleichzeitig mit der Erfassung eines aktualisierten Meßwertes Uen erneut zu berechnen. Erfindungsgemäß erfolgt deren Aktualisierung mit einer erheblich niedrigeren Wiederholungsrate, so daß eine besonders vorteilhafte wesentliche Entlastung des Prozessors P erreicht werden kann.

Gemäß den beispielhaften Voraussetzungen weisen alle Elemente von Gleichung 10 die binäre Meßwerte - Wortbreite von WP = 16 Bit auf. Diese hat zur Folge, daß die Multiplikation von NF(Uen) mit 65536 im Zähler von Gleichung 10 ein 32 Bit Wort ergibt. Bei dessen Division durch KF(Uen) stellt das Ergebnis ein 16 Bit Wort und der Rest ebenfalls ein 16 Bit Wort dar. Die gemäß der obigen Gleichung 4 desweiteren benötigte Konstante K stellt somit nach Elimination des Restes das erste dieser beiden 16 Bit Worte dar.

Nach Zusammenfassung der Gleichungen 9 und 10 ergibt sich :

$$KMD(Uen) = \frac{K * [AMD(Uen) - OFD]}{65536} \qquad \text{(Gl.11)}$$

Das Produkt der 16 Bit breiten Konstante K mit dem ebenfalls 16 Bit breiten Klammerausdruck im Zähler des Quotienten von Gleichung 11 ist ein 32 Bit Wort. Aufgrund der erfindungsgemäß vorteilhaften Auswahl des Verschiebungsfaktors VF = 65536 ist der Quotient nun nicht mehr unter Aufwendung einer Vielzahl von Prozessorzyklen zu bestimmen. Vielmehr ist die Division durch 65536 gleichbedeutend damit, daß zur Ermittlung des aufbereiteten Meßwertes KMD(Uen) in binärer Form als Ergebnis nur noch die beiden höherwertigen Bytes des 32 Bit Wortes von Gleichung 11 herangezogen werden müssen. Die an sich außerordentlich rechenzeitintensive Division in Gleichung 11 kann somit erfindungsgemäß vermieden und auf einfache Ladeoperationen für die beiden höherwertigen Bytes des 32 Bit Wortes reduziert werden.

Auch bei der Bestimmung der Konstanten K im Prozessor P entsprechend der obigen Gleichung 10 ergeben sich bei Anwendung des erfindungsgemäßen Verfahrens erhebliche Vorteile. So muß auch die Multiplikation NF(Uen) *65536 im Zähler praktisch nicht ausgeführt werden. Vielmehr ist die Multiplikation des 16 Bit Wortes NF(Uen) mit 65536 gleichbedeutend damit, daß als Ergebnis ein 32 Bit Wort entsteht, dessen beide höherwertigen Bytes mit dem Wert des ursprünglichen NF(Uen) übereinstimmen. Auch hier kann die an sich rechenzeitintensive Multiplikation erfindungsgemäß vermieden und auf einfache Ladeoperationen für die beiden höherwertigen Bytes des 32 Bit Wortes reduziert werden. Die verbleibende Division dieses 32 Bit Wortes durch KF(Uen) in Gleichung 11 muß zwar durchgeführt werden, erfindungsgemäß aber mit einer erheblich reduzierten Wiederholrate, da die Elemente von Gleichung 11 als zumindest vorübergehend konstant angesehen werden können.

Die in den obigen Gleichungen 7 bis 11 in Form des Korrekturfaktors KF(Uen) enthaltenen binären Werte für RFD, OFD können in einer mit der Erfassung, Digitalisierung und Aufbereitung von analogen Meßwerten AMD(Uen) übereinstimmenden Weise aus den analogen Meßwerten für die Referenzspannung Uref und die Bezugsspannung Gnd abgeleitet werden.

Die Erfindung hat somit den Vorteil, daß mit einem Prozessor P, der voraussetzungsgemäß über eine eingeschränkte Wortbreite verfügt, z.B. mit einem kostengünstigen 8 Bit Prozessor, ohne Einschränkungen in der Genauigkeit und Bearbeitungsgeschwindigkeit analoge Meßwerte, welche in Digitalwerte mit größerer Wortbreite konvertiert werden, z.B. in 16 Bit Worte, verarbeitet werden können. Es ist somit trotz einem Prozessor mit eingeschränkter Wortbreite ein hoher Datendurchsatz erreichbar, d.h. die analogen Meßwerte Ue1...Uen am Eingang der Schaltung in der Figur können mit einer unverändert hohen Abtastrate eingelesen werden.

**Patentansprüche**

1. Verfahren zur schnellen digitalen Erfassung und Aufbereitung von analogen Meßwerten (Ue1 ... Uen) in einer Meßwerterfassungsvorrichtung mit einem digitalen Prozessor (P), welcher gegenüber der Wortbreite (WM) der Meßwerte in digitalisierter Form (AMD,AMD(Uen)) eine eingeschränkte binäre Wortbreite (WP) aufweist, wobei

    a) für die Aufbereitung eines Meßwertes in digitalisierter Form (AMD, AMD(Uen)), bevorzugt getrennt für jeden Meßwert (AMD(Uen)), binäre Faktoren (NF,KF) vorgesehen sind,

    b) ein binäres Element (K) vom Prozessor (P) mit einer Aktualitätsrate gebildet wird, welche geringer ist als ein zur Erfassung und Aufbereitung der Meßwerte (AMD(Uen)) dienender Abtastzyklus, indem die binären Faktoren (NF,KF) in einem Zähler um einen binären Verschiebungsfaktor (VF) erweitert werden (Gl.3), und

    c) das Produkt aus dem binären Element (K) und dem jeweiligen digitalisierten Meßwert (AMD(Uen)) in einem Nenner um den Verschiebungsfaktor (VF) erweitert wird (Gl.4), wobei

d) der binäre Verschiebungsfaktor (VF) abhängig von der binären Wortbreite (WP) des Prozessors (P) so ausgewählt wird, daß die digitale Zusammenfassung des Produktes (K*AMD) mit dem im Nenner befindlichen Verschiebungsfaktor (VF) einer Ladeoperation höherwertiger Bits des Produktes durch den Prozessor (P) entspricht.

2. Verfahren nach Anspruch 1, wobei als Faktoren zur Aufbereitung eines Meßwertes in digitalisierter Form (AMD), AMD(Uen)) vorgesehen sind

a) ein binärer Normierungsfaktor (NF) zur Meßbereichsanpassung, und

b) ein binärer Korrekturfaktor (KF) zur Kompensation von in der Meßwerterfassungsvorrichtung auftretenden Störeinflüssen.

3. Verfahren nach Anspruch 2, wobei der binäre Korrekturfaktor (KF) der binären Differenz aus dem binären Wert (RFD) einer Referenzspannung (Uref) und dem binären Wert (OFD) einer Bezugsspannung (Gnd) der Meßwerterfassungsvorrichtung entspricht (Gl.7).

4. Verfahren nach Anspruch 3, wobei Referenzspannung (Uref) und Bezugsspannung (Gnd) in gleicher Weise wie analoge Meßwerte (Ue1 ... Uen) von der Meßwerterfassungsvorrichtung erfaßt, digitalisiert und aufbereitet werden.

**Claims**

1. Method for the rapid digital acquisiticn and conditioning of analog measured values (Ue1 ... Uen) in a measured value acquisition device with a digital processor (P) which, compared with the word length (WM) of the measured values in digitalized form (AMD, AMD(Uen)) has a restricted binary word length (WP),

a) binary factors (NF, KF) being preferably provided separately for each measured value (AMD(Uen)) for the conditioning of a measured value in digitalized form (AMD, AMD(Uen)),

b) a binary element (K) being formed by the processor (P) at an update rate which is lower than a sampling rate which is used to acquire and condition the measured values (AMD(Uen)), the binary factors (NF, KF) being expanded (Equation 3) in a counter by a binary displacement factor (VF), and

c) the product of the binary element (K) and the respective digitalized measured value (AMD(Uen)) being expanded (Equation 4) in a denominator by the displacement factor (VF),

d) the binary displacement factor (VF) being selected as a function of the binary word length (WP) of the processor (P) in such a way that the digital combination of the product (K*AMD) with the displacement factor (VF) located in the denominator corresponds to a loading operation of higher-order bits of the product by the processor (P).

2. Method according to Claim 1, in which case the following are combined as factors for conditioning a measured value in digitalized form (AMD, AMD(Uen))

a) a binary scaling factor (NF) for measurement range adaptation, and

b) a binary correction factor (NF, KF, VF) for compensating interference influences occurring in the measured value acquisition device.

3. Method according to Claim 2, the binary correction factor (KF) corresponding to the binary difference between the binary value (RFD) of a reference voltaae (Uref) and the binary value (OFD) of a reference voltage (Gnd) of the measured value acquisition device (Equation 7).

4. Method according to Claim 3, reference voltage (Uref) and reference voltage (Gnd) (Equation 7) being acquired, digitalized and conditioned by the measured value acquisition device in the same way as analog measured values (Ue1 ... Uen).

**Revendications**

1. Procédé pour la saisie et la préparation numériques rapides de valeurs mesurées analogiques (Ue1 à Uen) dans un dispositif de saisie de valeurs mesurées comportant un processeur numérique (P) qui a une longueur de mot binaire (WP) réduite par rapport à la longueur ce mot (WM) des valeurs mesurées sous forme numérisée (AMD, AMD(Uen)), dans lequel

   a) pour la préparation d'une valeur mesurée sous forme numérisée (AMD, AMD(Uen)), on prévoit des facteurs binaires (NF, KF), de préférence séparément pour chaque valeur mesurée (AMD(Uen)),
   b) on forme un élément binaire (K) au moyen du processeur (P) avec un taux d'actualisation qui est inférieur à un cycle d'échantillonnage servant à la saisie et à la préparation des valeurs mesurées (AMD(Uen)), les facteurs binaires (NF, KF) dans un numérateur étant complétés par un facteur de décalage binaire (VF) (équation 3), et
   c) on complète le produit de l'élément binaire (K) et de la valeur mesurée numérisée considérée (AMD(Uen)) dans un dénominateur par le facteur de décalage (VF) (équation 4),
   d) le facteur de décalage binaire (VF) étant choisi en fonction de la longueur de mot binaire (WP) du processeur (P) de telle sorte que le regroupement numérique du produit (K * AMD) avec le facteur de décalage (VF) se trouvant au dénominateur correspond à une opération de chargement de bits de grand poids du produit par le processeur (P).

2. Procédé selon la revendication 1, dans lequel on prévoit comme facteurs pour la préparation d'une valeur mesurée sous forme numérisée (AMD, AMD(Uen)) :

   a) un facteur de cadrage (NF) binaire pour l'adaptation de domaine de mesure, et
   b) un facteur de correction (KF) binaire pour la compensation d'influences parasites apparaissant dans le dispositif de saisie de valeurs mesurées.

3. Procédé selon la revendication 2, dans lequel le facteur de correction (KF) binaire correspond à la différence binaire entre la valeur binaire (RFD) d'une tension de référence (Uref) et la valeur binaire (OFD) d'une tension de base (Gnd) du dispositif de saisie de valeurs mesurées (équation 7).

4. Procédé selon la revendication 3, dans lequel on saisit, numérise et prépare la tension de référence (Uref) et la tension de base (Gnd) de la même manière que des valeurs mesurées analogiques (Ue1 à Uen) au moyen du dispositif de saisie de valeurs mesurées.